# FASCICULE DE BREVET EUROPEEN

(11) **EP 1 071 122 B1**
(45) Date de publication et mention de la délivrance du brevet: **12.05.2004**
(21) Numéro de dépôt: 00402053.3
(22) Date de dépôt: 19.07.2000
(51) Int. Cl.: H01L 21/3105

(54) **Procédé de correction des effets topographiques sur substrat en micro electronique**
Verfahren zur Korrektur der Topographie von mikroelektronischen Substraten
Process for correcting the topography of microelectronic substrates

(30) Priorité: 22.07.1999 FR 9909521
(43) Date de publication de la demande: 24.01.2001
(73) Titulaire: FRANCE TELECOM, 75015 Paris (FR)
(72) Inventeur: Schiltz, André, 38330 Saint-Ismier (FR); Paoli, Maryse, 38190 Villard Bonnot (FR); Schiavone, Patrick, 38190 Villard Bonnot (FR); Prola, Alain, 38100 Grenoble (FR)
(74) Mandataire: Texier, Christian

(56) Documents cités:
- US-A- 5 580 826
- SCHILTZ ET AL: "Two layer resist etch-back planarizaiton process coupled to chemical mechanical polishing for sub-0.18 micron shallow trench isolation technology" PROCEEDINGS OF THE SPIE : EMERGING LITHOGRAPHIC TECHNOLOGIES III, vol. 3676, 15 - 17 mars 1999, pages 802-811, XP000901888 Santa-Clara, CA, USA

## Description

La présente invention concerne le domaine de la fabrication de produits semi-conducteurs sous forme de circuits intégrés.

Elle a trait aux techniques photo-lithographiques et d'obtention de planéité utilisées dans la fabrication des circuits intégrés. La présente invention concerne plus particulièrement encore les techniques qui permettent l'obtention de la planéité des substrats en lithographie avancée, à savoir la planarisation et le polissage mécano-chimique.

Dans les étapes de fabrication d'un circuit intégré, des couches de matériaux semi-conducteurs, isolantes ou métalliques doivent être déposées, puis lithographiées et gravées. Ces couches peuvent être de topographies variables, planes ou en relief.

De façon conventionnelle, la lithographie s'effectue par dépôt d'une couche de résine photosensible sur une couche à lithographier, dont on ne sensibilise que certaines zones qui seront ensuite développées dans un développeur approprié à la nature chimique de la résine, révélant ainsi des zones spécifiques de la couche à lithographier.

L'étape de lithographie, comme les étapes de dépôt des différents matériaux, s'effectue avec un bien meilleur résultat lorsque la surface sousjacente est plane. Cependant, la topographie des substrats augmente au cours de la fabrication des circuits intégrés, au fur et à mesure des dépôts et gravures successifs au point de rendre critique la réalisation de certaines étapes.

C'est pourquoi on utilise des techniques de "planarisation" afin d'aplanir la topographie dès le début de la fabrication des circuits intégrés.

Ces techniques peuvent être une planarisation dénommée "etch-back", qui consiste à déposer une couche de résine qui aplanit le relief, la planéité étant transférée dans le substrat par gravure plasma, ou le polissage mécano-chimique qui consiste à abraser une couche épaisse d'isolant ou de conducteur déposée sur le substrat.

L'obtention de la planéité est vitale lors des premières étapes de la fabrication des circuits intégrés et en particulier, lors de la fabrication des zones d'isolement des transistors.

Aujourd'hui, les zones d'isolement sont généralement aplanies par polissage mécano-chimique.

Cette technique rencontre cependant certaines limitations liées aux dimensions sans cesse réduites pour la fabrication de circuits d'une densité toujours plus grande. Une méthode d'amélioration des performances du polissage mécano-chimique est l'utilisation d'une technique de préplanarisation par contre-masquage et gravure.

On va préciser ci-dessous ces techniques connues de planarisation.

La technique de polissage mécano-chimique remplace généralement les autres techniques de planarisation depuis quelques années en raison de sa meilleure uniformité à longue distance et son meilleur débit.

Le principe de la technique de polissage mécano-chimique est l'abrasion de couches (généralement de la silice et plus récemment de cuivre) par le frottement mécanique d'un tissu abrasif (mouvement rotatif ou de translation) sous une certaine pression et en présence d'une solution chimiquement agressive vis à vis de la couche à abraser. L'abrasion combinée chimique/mécanique permet une vitesse d'abrasion élevée et le réglage de l'anisotropie d'attaque (l'attaque chimique est plus isotrope, tandis que l'attaque mécanique est plus directive) sur toute la surface de la plaquette, avec une bonne uniformité globale.

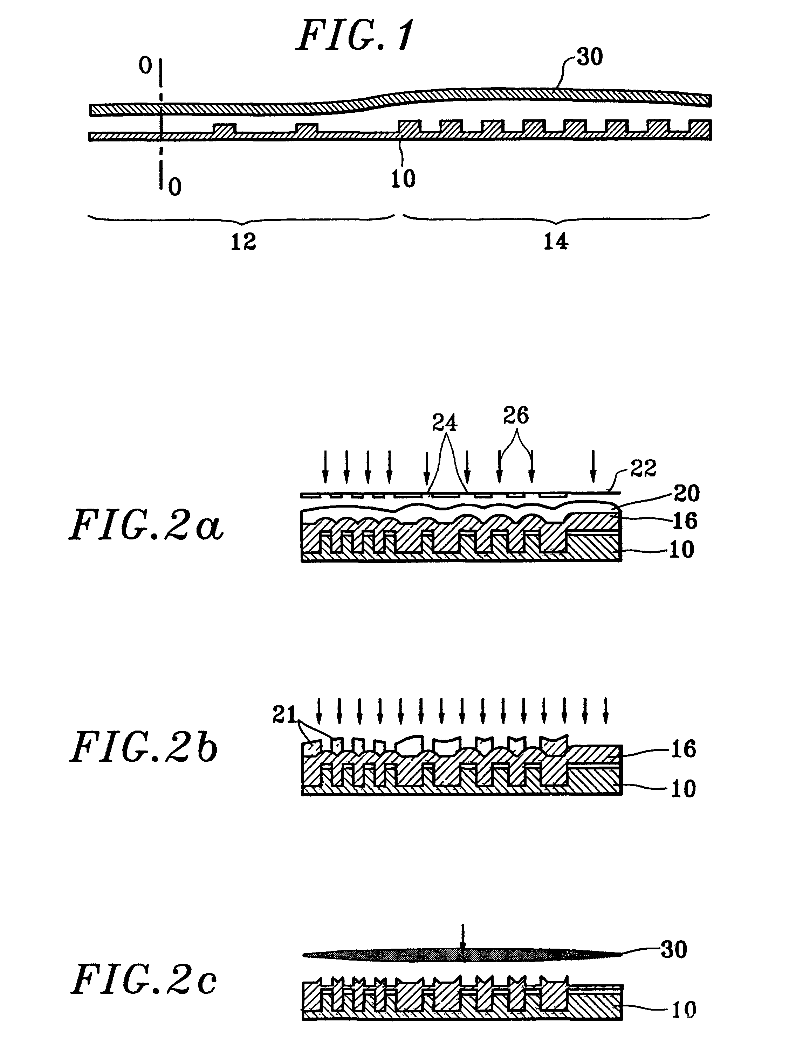

Cependant, si l'uniformité est bonne à très longue distance, la technique de polissage mécano-chimique - comme les autres techniques de planarisation - reste sensible à la densité topographique. La sensibilité à la densité topographique est de l'ordre de 100 microns pour les techniques utilisant l'aplanissement procuré par le dépôt d'une couche de résine et il est de l'ordre du millimètre pour la technique de polissage mécanochimique. La conséquence est que pour des puces où il existe des zones très denses de quelques millimètres de largeur séparées par des zones peu denses, on observe un effet appelé "dishing effect" dans la littérature anglaise et qui se manifeste par un effet de creusement dans les zones peu denses (qui offrent peu de résistance à l'abrasion) ou de bosselage pour les zones denses (qui résistent à l'abrasion) comme représenté sur la figure 1 annexée.

Sur cette figure 1, on a référencé 10 un substrat semi-conducteur comprenant des zones 12 peu denses et des zones 14 plus denses et on a schématisé en 30 un tissu utilisé pour le polissage mécanique, ici par rotation sur le substrat 10 autour d'un axe 0-0 perpendiculaire au plan moyen du substrat 10.

En raison de cet effet lié à la densité, la technique de polissage mécano-chimique est limitée à la planarisation de structures de dimensions supérieures à 0,3 µm.

Pour des technologies inférieures, la technique de polissage mécano-chimique est précédée d'une pré-planarisation par contre-masquage et gravure de tous les éléments topographiques positifs comme illustré sur les figures 2.

Plus précisément sur ces figures 2a, 2b, 2c on a schématisé en 10 un substrat comportant différentes couches de matériau semi-conducteur, isolant ou métallique, selon la fonction recherchée, dont la couche supérieure 16, par exemple une couche d'oxyde, présente initialement, comme on le voit sur la figure 2a, une topographie marquée, c'est-à-dire à reliefs.

Comme représenté sur la figure 2a, une couche de résine photosensible 20 est déposée sur la couche 16.

Puis un masque 22 est superposé à cette couche photosensible 20. Le masque 22 comporte des ouvertures 24 de géométrie adaptée aux reliefs en saillie de la couche 16 et respectivement superposées à ceux-ci.

Un flux d'irradiation 26 auquel est sensible la résine 20, par exemple un flux ultraviolet, est appliqué sur la couche de résine 20, à travers le masque 22.

Puis la couche de résine 20 est développée.

On obtient alors comme illustré sur la figure 2b, des éléments 21 de la couche de résine 20 demeurant sur la couche supérieure 16 du substrat entre les reliefs marqués de cette couche 16.

Il reste alors à procéder au polissage mécanique à l'aide d'une toile 30, comme illustré sur la figure 2c.

Cette technique connue illustrée sur les figures 2a, 2b, 2c est généralement dénommée "pré-planarisation par contre-masquage et gravure directe de structures d'isolement latéral par tranchées peu profondes STI (shallow trench isolation) avant polissage mécano-chimique".

Les techniques antérieures décrites précédemment sont limitées à des technologies de 0,3 micron lorsque la technique de polissage mécano-chimique représentée sur la figure 1 est utilisée seule.

Elles sont limitées à des technologies de 0,25 micron pour la technique de pré-planarisation par contre-masquage et gravure des éléments topographiques positifs telle qu'illustrée sur la figure 2.

En effet, cette dernière technique est limitée en raison des problèmes de désalignement possible entre le masque 22 et la topographie du dispositif semi-conducteur sous-jacent, inhérents à la photo lithographie. Le désalignement peut être de l'ordre de 0,1 µm, et peut conduire à une surgravure indésirable des zones d'isolement lorsque le masque 22 est décalé.

Pour des technologies inférieures ou égales à 0,18 microns, une autre technique est donc nécessaire.

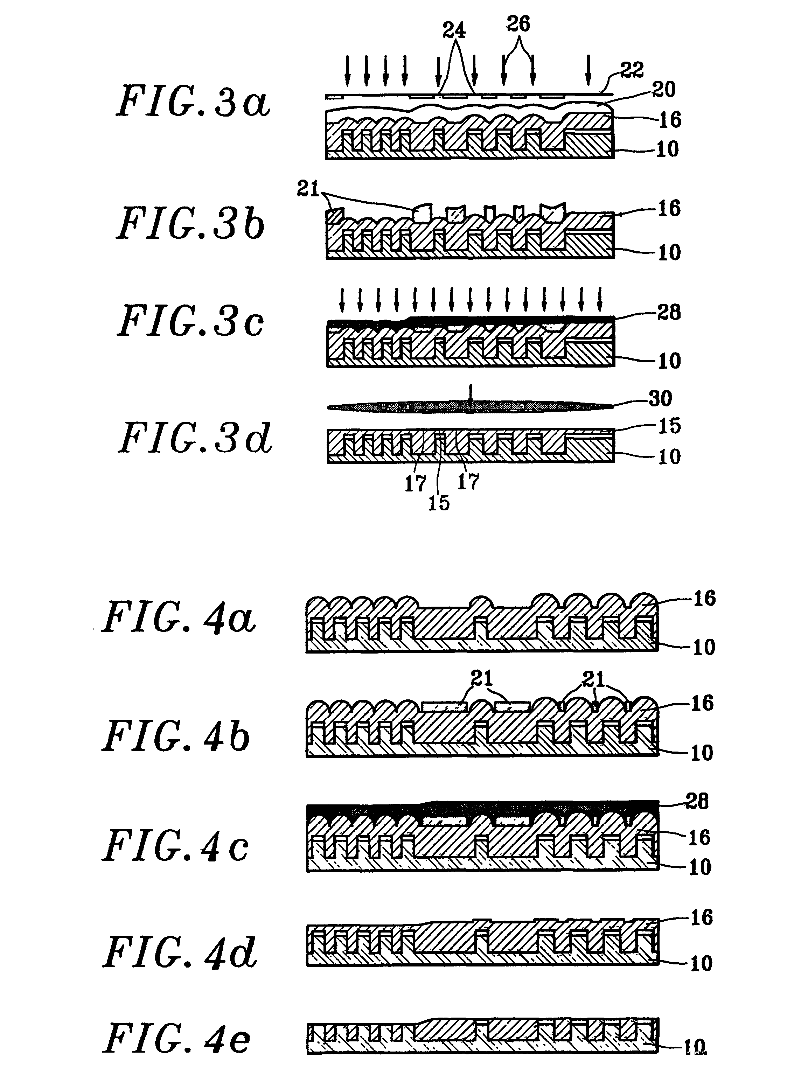

On utilise parfois une technique de pré-planarisation par dépôt de deux couches successives de résine. Cette technique est publiée sous le nom de TLP (two layers planarization). On en trouvera un descriptif dans le document [1]. Cette technique est schématisée sur la figure 3. On retrouve sur la figure 3a un substrat 10 comportant différentes couches de matériau semi-conducteur, isolant ou métallique, dont la couche supérieure 16 présente initialement (voir figure 3a) une topographie marquée.

Une première couche de résine photosensible 20 est déposée et lithographiée avec un contre-masque spécial 22 comportant une réduction de ses ouvertures 24 (voir figure 3a) et par conséquent de la taille des motifs de résine résultant 21 servant à masquer les zones d'isolement sur le substrat 10 (voir figure 3b).

Ceci permet un centrage du masque insensible au désalignement et autorise le fluage thermique de la résine dans les creux d'isolement (voir figure 3c). Le traitement thermique permet également la réticulation de la première couche 20, ce qui rend insoluble et autorise le dépôt d'une deuxième couche 28.

La deuxième couche 28 planarise les ondulations résiduelles et permet l'obtention d'une surface quasiment plane sur toute la surface comme on le voit sur la figure 3c.

Après le dépôt des deux couches de résine, la planéité de la surface est transférée dans le substrat par gravure plasma comme schématisé sur les figures 3c et 3d, dans des conditions telles que la résine 20, 28 et la couche d'oxyde sous-jacente 16 se gravent à la même vitesse. La gravure est arrêtée à 100 nanomètres au-dessus de la couche des zones actives, par exemple d'une couche de nitrure, et les plaques sont transférées vers un poste de polissage mécano-chimique où la planarisation est continuée avec arrêt dans la couche de nitrure afin d'obtenir une structure plane avec des zones d'isolement noyées dans le silicium.

Cependant, cette technique est elle aussi sensible à la densité topographique car les zones du substrat comportant de très petits motifs sont exclues en raison de la réduction de la taille des motifs de résine (voir figure 3b) due à la réduction de la taille des ouvertures 24 du masque 22. Et si ces zones sont grandes, elles conduisent à un phénomène similaire au "dishing effect" rencontré en polissage mécano-chimique pur, comme représenté sur la figure 4.

Sur la figure 4, on a illustré :
- en figure 4a, le substrat 10 comportant la couche en relief 16 avant le processus de planarisation,
- en figure 4b, la structure après dépôt et photo lithographie de la première couche 20,
- en figure 4c, la structure après dépôt et recuit de la deuxième couche 28,
- en figure 4d, la structure après planarisation (transfert du profil aplani) par plasma, et
- en figure 4e, la structure après polissage mécano-chimique.

Sur la figure 4e, on observe un différentiel de cote entre les zones denses (de moindre épaisseur) et les autres zones, résultant notamment de l'absence de traces de la première couche 20 avant dépôt de la seconde couche 28 (et par la force des choses avant gravure plasma et polissage mécano-chimique) au dessus des zones denses.

Le document Proc. of the SPIE, vol. 3676, pages 802-811 décrit un procédé de planarisation de tranchées d'isolation comprenant :
- le dépôt d'une première couche de résine sur une structure à planariser,
- l'exposition de cette résine avec un masque créant des motifs sur les zones de faible et forte densité topographique, les motifs dans les zones à faible densité ayant une taille inférieure aux tranchées à planariser, les motifs sur les zones de haute densité ayant la forme d'une grille à 45°,
- le fluage de ladite résine,
- le dépôt d'une seconde couche de résine,
- le transfert par gravure plasma dans la couche à planariser, et
- le polissage mécano-chimique de la structure.

Dans ce contexte, la présente invention a pour but de proposer de nouveaux moyens permettant d'améliorer la planéité des dispositifs semi-conducteurs pendant leur processus de fabrication.

Ce but est atteint dans le cadre de la présente invention grâce à un procédé tel que défini en revendication 1 annexée, laquelle est délimiteé sous forme d'un préambule et d'une partie caractérisante par rapport au document précité Proc. of the SPIE.

D'autres caractéristiques, buts et avantages de la présente invention, apparaîtront à la lecture de la description détaillée qui va suivre, et en regard des dessins annexés, donnés à titre d'exemple non limitatif et sur lesquels :
- la figure 1 représente schématiquement l'effet de creusement obtenu sur des zones peu denses et inversement l'effet de polissage obtenu sur des zones denses lors de polissage classique mécano-chimique,
- les figures 2a, 2b, et 2c représentent trois étapes principales successives d'un processus classique de pré-planarisation par contre-masquage et gravure directe,
- les figures 3a, 3b, 3c et 3d représentent quatre étapes principales successives d'un processus classique de pré-planarisation par technique double couche et transfert de planéité par gravure plasma avant polissage mécano-chimique,
- les figures 4a, 4b, 4c, 4d et 4e représentent schématiquement la structure obtenue lors de cinq étapes successives de ce processus,
- les figures 5a, 5b, 5c, 5d et 5e représentent schématiquement la structure obtenue lors de cinq étapes successives de la mise en oeuvre du procédé conforme à la présente invention,
- la figure 6 représente la structure de la première couche de résine après photo lithographie à l'aide du masque possédant des mailles standard, et
- la figure 7 représente une vue de la même couche après fluage.

Comme indiqué précédemment, la présente invention a pour but de permettre l'obtention d'une planéité quasi parfaite sur l'ensemble d'une structure semi conductrice, quelles que soient les dimensions et la densité des motifs.

Pour cela, la présente invention propose de traiter différemment par photo lithographie, les zones d'une couche de résine, selon que ces zones sont superposées à des régions de forte densité de motifs ou de faible densité de motifs de la structure semi conductrice sous-jacente.

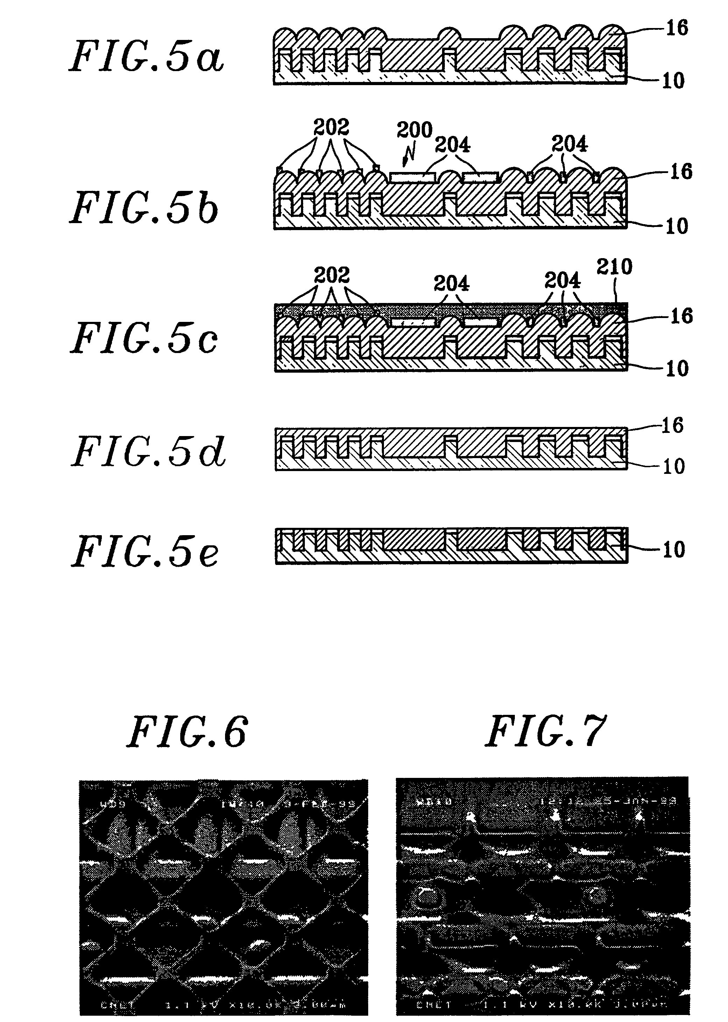

On a représenté sur la figure 5a, un substrat 10 comportant une couche en relief 16, avant le processus de planarisation.

Dans le cadre de la présente invention, après avoir déposé une première couche de résine 200 sur la structure à planariser, les zones de celle-ci superposées aux zones de forte densité de la topograhie sous-jacente, sont soumises à une photo lithographie à l'aide d'un masque possédant des mailles standard, c'est-à-dire des mailles sans coïncidence directe et univoque avec la topographie sous-jacente.

On notera que ce masque ne tient pas compte des motifs de faible dimension mais isolés.

En revanche, les zones de la couche de résine 200 superposées à des zones de faible densité de la structure semi conductrice sont soumises à une photo lithographie à l'aide d'un masque imposant des motifs de résine de taille inférieure aux zones d'isolement sous-jacentes à masquer.

Sur la figure 5b, on a référencé 202 les éléments de la première couche de résine 200 résultant de la photo lithographie à l'aide du masque à mailles standard et on a référencé 204, les éléments de cette couche de résine 200 superposées aux zones de faible densité de topographie.

Les masques utilisés pour assurer la photo lithographie de la couche de résine 200 respectivement en regard des zones de forte densité et en regard des zones de faible densité de la topographie peuvent être formées d'un masque commun ou de masques distincts.

On notera que tout comme le masque à mailles standard, le masque utilisé pour la photo lithographie au niveau des zones de faible densité de topographie est adapté pour exclure la couche de résine 200 au niveau des motifs de topographie isolés de petite dimension.

De préférence, dans le cadre de l'invention, le masque à mailles standard comporte des lignes en grillage, par exemple orientées à 45° entre elles.

Après photo lithographie complète de la première couche de résine 200, celle-ci est de préférence soumise à une étape de fluage thermique, de sorte que grâce à la viscosité et à la tension de surface résine fondue 200/silice 16 sous-jacente, la résine fondue 202, 204 coule dans les zones d'isolement.

Ceci ressort notamment des figures 6 et 7 qui représentent respectivement la couche de résine 200 au niveau des zones de forte densité de topographie, respectivement avant et après fluage thermique.

Selon l'invention, l'on procède ensuite au dépôt d'une seconde couche de résine 210. Cette deuxième couche 210 conduit à une planéité quasi parfaite que l'on transfère dans la sous couche 16 par gravure plasma comme illustré sur la figure 5d. Il reste alors à procéder au polissage mécanochimique classique en soi, pour obtenir une structure quasi plane comme illustré sur la figure 5e.

Le procédé conforme à la présente invention permet d'obtenir ainsi une planéité finale excellente avec des variations topograhiques résiduelles inférieures à 50nm sur toute la plaque.

La largeur des lignes du masque à mailles standard et leur espacement, peut résulter d'un calcul de remplissage des zones denses à l'aide d'un modèle de planarisation tel que celui cité en référence [2].

Pour la préplanarisation de motifs du type STI de 0,2µm espacés de 0,3µm et d'une épaisseur de 0,4µm, la grille du masque peut correspondre à des lignes 0,5µm espacées de 2µm.

Par ailleurs, l'épaisseur de résine peut être fixée à une hauteur d'environ 0,6 à 0,7µm pour des motifs STI de 0,4 à 0,5µm de hauteur.

Le masque utilisé pour la photo lithographie de la couche de résine 200 au niveau des zones de faible densité présente de préférence typiquement une réduction de taille comprise entre 0,2 et 0,8µm par rapport à la topographie réelle sous-jacente.

La lithographie des deux masques appliquée à la première couche de résine 200 est effectuée de préférence de manière successive sur le photorépéteur pour éviter de perdre du temps à réaligner la plaquette et le deuxième masque.

On notera par ailleurs que dans le cadre du procédé conforme à la présente invention, la largeur des lignes grillagées formée dans la couche de résine 200 est ajusté pour un masque donné, selon la hauteur des dispositifs STI, grâce à l'utilisation d'une dose d'insolation plus ou moins grande appliquée au masque à mailles standard, le masque superposé aux zones de faible densité étant de préférence quant à lui insolé dans des conditions standards.

Cet ajustement permet de corriger, voir de remplacer le calcul de l'espacement des lignes grillagées afin d'obtenir un remplissage optimum des grandes zones denses qui conduisent à une planéité globale quasi parfaite.

On notera par ailleurs que le procédé conforme à la présente invention, permet l'utilisation d'une résine photosensible "i.line", c'est-à-dire une résine photosensible destinée généralement aux dessins de technologie à 0,35µm. Cette utilisation est possible en raison de l'exclusion de tous les petits motifs du contre masque.

Ainsi, la présente invention permet une mise en oeuvre dite "non critique", car susceptible d'être réalisée à l'aide de résine et équipement très classiques, procédure beaucoup moins difficile à mettre en oeuvre et moins chère que les technologies plus récentes de type DUV.

### REFERENCES

[1] A. Schiltz and M. Pons, J. of the Electrochem. Soc., Vol. 133, 178 (1986)
[2] A. Schiltz, Jpn. J. Appl. Phys., Vol. 34, pp 4185-4194 (1995)

## Revendications

1. Procédé de planarisation des effets topographiques sur substrat en microelectronique, ledit substrat comprenant des zones de forte densité et des zones de faible densité de topographies en relief, ces zones de topographies en relief étant entourées de zones d'isolement, comprenant les étapes consistant à :
i) déposer une première couche de résine (200) sur la structure à planariser,
ii) soumettre cette couche de résine (200) au niveau de ses zones superposées aux zones de faible densité de topographie sous-jacentes à une photo lithographie à l'aide d'un masque imposant des motifs de résine (204) de taille inférieure aux zones d'isolement sous-jacentes à masquer,
iii) soumettre la couche de résine (200) au niveau de ses zones superposées aux zones de forte densité de topographie sous-jacentes à une photo lithographie à l'aide d'un masque possédant des mailles en grillage sans coïncidence univoque avec la topographie sous-jacente,
iv) développer ladite première couche de résine (200),
v) soumettre la première couche de résine (200) ainsi photo lithographiée à un fluage thermique de telle sorte que les zones restantes de la première couche de résine recouvrent les zones d'isolement,
vi) déposer une seconde couche de résine (210) sur la surface du substrat et la surface de la dite première couche de résine fluée,
vii) opérer une gravure plasma dans laquelle les première et seconde couches de résines et le substrat sont gravés à la même vitesse, puis
vii) opérer un polissage mécano chimique,
**caractérisé en ce que**
l'étape iii) de photolithographie des zones de forte densité topographiques à l'aide du masque à mailles en grillage sans coïncidence univoque avec la topographie sous-jacente comprend un ajustement de l'insolation pour varier la taille des motifs en grillage afin d'obtenir un remplissage optimum des zones à forte densité de topographie.

2. Procédé selon la revendication 1, **caractérisé par le fait que** les étapes ii) et iii) sont réalisées à l'aide d'un masque commun comportant des zones respectivement dédiées aux zones de faible densité et aux zones de forte densité de topographie sous-jacente.

3. Procédé selon la revendication 1, **caractérisé par le fait que** les étapes ii) et iii) sont réalisées à l'aide de masques distincts.

4. Procédé selon l'une des revendications 1 à 3, **caractérisé par le fait que** les moyens formant masque sont adaptés pour exclure la couche de résine (200) au niveau des motifs de zones d'isolement isolées de petites dimensions.

5. Procédé selon l'une des revendications 1 à 4, **caractérisé par le fait que** les moyens formant masque utilisés à l'étape iii) comprennent des lignes en grillage à 45°.

6. Procédé selon l'une des revendications 1 à 5, **caractérisé par le fait que** les moyens formant masque comprennent des lignes d'une épaisseur de 0,5µm espacée de 2µm.

7. Procédé selon l'une des revendications 1 à 6, **caractérisé par le fait que** l'étape consistant à ajuster l'insolation utilisée à l'étape iii) pour obtenir un remplissage optimum des grandes zones denses de topographie est opérée en fonction de la hauteur des structures sous-jacentes.

## Claims

1. A method of planarizing topographical effects on a microelectronic substrate, said substrate comprising high-density zones having topography in relief and low-density zones having topography in relief, the zones having topography in relief being surrounded by isolating zones, the method comprising the steps consisting in:
i) depositing a first layer of resin (200) on the structure to be planarized;
ii) subjecting said resin layer (200) in its zones superposed over underlying zones of low topographical density to photolithography by means of a mask imposing resin patterns (204) of a size smaller than the underlying isolating zones to be masked;
iii) subjecting the resin layer (200) in its zones superposed on underlying zones of high topographical density to photolithography through a mask possessing a grid mesh without any one-to-one coincidence with the underlying topography;
iv) developing said first layer of resin (200);
v) subjecting the first layer of resin (200) as photolithographed in this way to thermal flow so that the resulting zones of the first layer of resin cover the isolating zones;
vi) depositing a second layer of resin (210) on the surface of the substrate and on the surface of said first layer of resin that has been caused to flow;
vii ) performing plasma etching in which the first and second layers of resin and the substrate are etched at the same rate; and then
viii) performing mechanical and chemical polishing,
the method being **characterized in that** step iii) of photolithography of the zones of high topographical density through the mask having a grid mesh without any one-to-one coincidence with the underlying topography comprises adjustment of the exposure in order to vary the size of the grid pattern so as to obtain optimum filling of the zones of high topographical density.

2. A method according to claim 1, **characterized by** the fact that steps ii) and iii) are performed using a common mask having zones dedicated respectively to the low density zones and to the high density zones of the underlying topography.

3. A method according to claim 1, **characterized by** the fact that steps ii) and iii) are performed using distinct masks.

4. A method according to any one of claims 1 to 3, **characterized by** the fact that the mask-forming means are adapted to exclude the resin layer (200) from isolated isolating zone patterns of small dimensions.

5. A method according to any one of claims 1 to 4, **characterized by** the fact that the mask-forming means used in step iii) have grid lines at 45° to one another.

6. A method according to any one of claims 1 to 5, **characterized by** the fact that the mask-forming means have lines with a thickness of 0.5 µm that are spaced apart by 2 µm.

7. A method according to any one of claims 1 to 6, **characterized by** the fact that the step consisting in adjusting the exposure used in step iii) to obtain optimum filling of large topographically-dense zones is performed as a function of the height of the underlying structures.

## Patentansprüche

1. Verfahren zur Planarisierungskorrekur topographischer Effekte auf mikroelektronischem Substrat, wobei das Substrat Bereiche hoher und Bereiche geringer Relieftopographiedichte aufweist, wobei diese Relieftopographiebereiche von Isolationsbereichen umgeben sind, und das Verfahren folgende Schritte aufweist:
i) Abscheiden einer ersten Harzschicht (200) auf die zu planarisierende Struktur,
ii) Anwenden einer Photolithographie auf die Harzschicht (200) in Bezug auf die Bereiche, die über den darunterliegenden Bereichen niedriger Topographiedichte liegen, mittels einer Maske, die Harzmuster (204) mit geringerer Größe als die zu maskierenden Isolationsbereiche aufweist,
iii) Anwenden einer Photolithographie auf die Harzschicht (200) in Bezug auf die Bereiche, die über den darunterliegenden Bereiche hoher Topographiedichte liegen, mittels einer Maske, die Gittermaschen aufweist, welche nicht in eindeutiger Übereinstimmung mit der darunterliegenden Topographie sind,
iv) entwickeln der ersten Harzschicht (200),
v) Anwenden einer thermischen Kriechdehnung auf die so photolitographierten erste Harzschicht (200), derart, daß die von der ersten Harzschicht übriggebliebenen Bereiche die Isolationsbereiche bedecken,
vi) Abscheiden einer zweiten Harzschicht (210) auf die Substratoberfläche und die Oberfläche der ersten gedehnten Harzschicht,
vii) Durchführen einer Plasmaätzung, bei der die erste und die zweite Harzschicht und das Substrat mit gleicher Geschwindigkeit geätzt werden, danach
viii) Durchführen einer mechanisch-chemischen Polierung,
**dadurch gekennzeichnet, daß**
der Schritt iii) der Photolithographie der Bereiche hoher Topographiedichte mittels der Maske aus Gittermaschen ohne eindeutiger Übereinstimmung mit der darunterliegenden Topographie eine Anpassung der Bestrahlung umfaßt, um die Größe der Gittermuster zu variieren, um letztlich eine optimale Füllung der Bereiche mit hoher Topographiedichte zu erreichen.

2. Verfahren nach Anspruch 1, **dadurch gekennzeichnet, daß** die Schritte ii) und iii) mittels einer gemeinsamen Maske realisiert werden, welche Bereiche aufweist, die für die Bereiche niedriger Topographiedichte bzw. die darunterliegenden Bereiche hoher Topographiedichte bestimmt sind.

3. Verfahren nach Anspruch 1, **dadurch gekennzeichnet, daß** die Schritte ii) und iii) mittels verschiedener Masken realisiert werden.

4. Verfahren nach einem der Ansprüche 1 bis 3, **dadurch gekennzeichnet, daß** die Mittel, welche die Masken bilden, ausgelegt sind, die Harzschicht (200) in Bezug auf Muster von Isolationsbereichen kleiner Abmessungen auszuschließen.

5. Verfahren nach einem der Ansprüche 1 bis 4, **dadurch gekennzeichnet, daß** die bei Schritt iii) verwendeten Mittel, welche die Masken bilden, Gitterlinien mit 45° aufweisen.

6. Verfahren nach einem der Ansprüche 1 bis 5, **dadurch gekennzeichnet, daß** die Mittel, welche die Masken bilden, Linien mit einem Durchmesser von 0,5µm in einem Abstand von 2µm aufweisen.

7. Verfahren nach einem der Ansprüche 1 bis 6, **dadurch gekennzeichnet, daß** der Schritt, der darin besteht, die Bestrahlung anzupassen, und bei Schritt iii) benutzt wird, um eine optimale Füllung der großen Bereiche mit hoher Topographiedichte zu erzielen, in Abhängigkeit der Höhe der darunterliegenden Strukturen durchgeführt wird.
